(19) 

Europäisches
Patentamt
European
Patent Office
Office européen
des brevets

(11) **EP 2 639 345 A1**

(12) **EUROPEAN PATENT APPLICATION**
published in accordance with Art. 153(4) EPC

(43) Date of publication:
**18.09.2013   Bulletin 2013/38**

(21) Application number: **11840361.7**

(22) Date of filing: **09.11.2011**

(51) Int Cl.:
**C30B 29/38** (2006.01)

(86) International application number:
**PCT/JP2011/075793**

(87) International publication number:
**WO 2012/063853 (18.05.2012 Gazette 2012/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **10.11.2010   JP 2010252364**

(71) Applicants:
• **Fujikura Co., Ltd.
Tokyo 135-8512 (JP)**
• **National Institute of Advanced Industrial Science
and Technology
Tokyo 100-8921 (JP)**

(72) Inventors:
• **KAMATA Hiroyuki
Sakura-shi
Chiba 285-8550 (JP)**

• **KATOU Tomohisa
Tsukuba-shi
Ibaraki 305-8568 (JP)**
• **NAGAI Ichiro
Tsukuba-shi
Ibaraki 305-8568 (JP)**
• **MIURA Tomonori
Tsukuba-shi
Ibaraki 305-8568 (JP)**

(74) Representative: **HOFFMANN EITLE
Patent- und Rechtsanwälte
Arabellastrasse 4
81925 München (DE)**

(54)    **APPARATUS AND METHOD FOR PRODUCTION OF ALUMINUM NITRIDE SINGLE CRYSTAL**

(57)    The invention is an apparatus for production of an aluminum nitride single crystal that produces the aluminum nitride single crystal by heating an aluminum nitride raw material to sublimate the raw material, thereby to recrystallize the aluminum nitride onto a seed crystal, which includes a growth vessel that accommodates the aluminum nitride raw material, and is composed of a material that has corrosion resistance with respect to the aluminum gas generated upon sublimation of the aluminum nitride raw material, and a heating element that is arranged on the outside of the growth vessel, and heats the aluminum nitride raw material through the growth vessel, wherein the growth vessel includes a main body which has an accommodation section that accommodates the aluminum nitride and a lid which seals the accommodation section of the main body hermetically, and wherein the heating element is composed of a metal material containing tungsten.

Fig.1

EP 2 639 345 A1

**Description**

TECHNICAL FIELD

The present invention relates to an apparatus and a method for production of the aluminum nitride single crystal.

BACKGROUND ART

An aluminum nitride based-semiconductor has a broad band gap of 6.2 eV, and thus is expected to be used in a blue or ultraviolet light-emitting device, a white LED, a high-voltage or high-frequency power source IC and the like. In addition, an aluminum nitride single crystal has small lattice mismatch of 2.4% to gallium nitride, and thus is also expected as a substrate for growth when growing a gallium nitride based-semiconductor.

As a method of producing such aluminum nitride single crystal, various methods are known. For example, a flux method is known among solution methods, and a MOVPE method, a hydride gas phase accumulation method (Hydride Vapor Phase Epitaxy, HVPE), a sublimation method and the like are known among gas phase methods. Among them, the sublimation method is generally a dominant method with respect to manufacture of a bulk crystal due to great growth speed. The sublimation method is a method of growing a crystal by heating a crucible which is a growth vessel, establishing temperature difference between the upper part and the lower part of the crucible, sublimating a raw material that is placed in the lower part, and recrystallizing the sublimated gas in a growth section of the upper part that is at lower temperature than the temperature of the lower part. In this sublimation method, aluminum nitride powders are used as the raw material, and if the aluminum nitride powders are sublimated, aluminum gas and nitrogen gas are generated. The aluminum nitride single crystal is grown around 2000°C, but in this temperature region, corrosiveness of the generated aluminum gas is high. Therefore, a material that can be used in a crucible is limited. As such material, tantalum carbide (TaC) or tungsten (W) is known to be used (Non Patent Document 1 and Patent Document 1).

Specifically, it is disclosed in Non Patent Document 1 mentioned below that TaC crucible is installed on the inside of heating element made of graphite.

In addition, it is disclosed in Patent Document 1 mentioned below that damage of a crucible is eliminated by using a tungsten crucible that contains multiple tungsten crystals, and is composed of a wall structure configured to be expanded by absorption of aluminum.

PRIOR ART DOCUMENTS

NON PATENT DOCUMENT

Non Patent Document 1: C. Hartmann et al. Journal of Crystal Growth 310 (2008) 930

PATENT DOCUMENT

Patent Document 1: Japanese Patent Application National Publication (Laid- Open) No. 2005- 519841

SUMMARY OF THE INVENTION

PROBLEM TO BE SOLVED BY THE INTENTION

However, the methods for production of an aluminum nitride crystal using the crucibles described in Non Patent Document 1 and Patent Document 1 described above have the following problems.

Namely, when using the crucible described in Non Patent Document 1, there was a problem that the carbon is largely mixed into the grown aluminum nitride. As described above, when AlN crystal is mixed with impurities such as the carbon, the crystal quality is lowered. In addition, when AlN crystal is mixed massively with the carbon, AlN is grown with this carbon as an origin, resulting in multi- crystallization.

On the other hand, when using the crucible described in Patent Document 1, the tungsten crucible reacts with aluminum gas at a high temperature of 2320°C. As a result, difference of the thermal expansion coefficients occurs in the crucible between a spot where there is reaction of the tungsten crucible and aluminum gas, and a spot where there is no such reaction, and the crucible may be likely damaged at the time of temperature-fall. In addition, even if the crucible is not damaged, the crucible is deformed before and after the growth due to change of the crucible volume, and it becomes difficult to use the crucible repetitively. Particularly, tungsten is expensive in comparison to carbon that is generally well used as a crucible material, and thus impossibility of repetitive use is a problem in the context of industrial use.

The invention has been done in view of the circumstances described above, and the object thereof is to provide an apparatus and a method for production of an aluminum nitride single crystal, which can sufficiently lower the mixing amount of carbon into the aluminum nitride crystal, and allows repetitive use.

MEANS FOR SOLVING PROBLEM

In order to resolve the problems described above, the inventors investigated the cause for mixing of the carbon into the aluminum nitride single crystal in Non Patent Document 1. Namely, the inventors investigated whether the carbon mixed into the aluminum nitride single crystal is derived from the TaC crucible which is a growth vessel, or the carbon is derived from the heating element made of graphite arranged on the outside of the Tac crucible. In the original expectation, the inventors thought that the carbon from heating element made of graphite is unlikely mixed with the aluminum nitride single crystal since the TaC crucible is sealed hermetically. Accordingly, the inventors thought that the carbon mixed into the aluminum nitride single crystal is derived from the TaC crucible. However, the inventors found unexpectedly that the carbon mixed into the aluminum nitride single crystal is mainly derived not from the TaC crucible, but from the heating element made of graphite arranged on the outside of the TaC crucible. Then, the inventors considered disposition of a heating element composed of tungsten as a heating element arranged on the outside of the TaC crucible in order to prevent the carbon derived from the heating element from mixing into the aluminum nitride single crystal. Herein, it was considered that aluminum gas generated in the TaC crucible is leaked out of the TaC crucible, and reacts with the heating element of tungsten, which causes damage of the heating element composed of tungsten as a result since the carbon of the heating element made of graphite arranged on the outside of the TaC crucible is mixed into the single crystal. However, unexpectedly, damage of the heating element composed of tungsten was not seen. Thus, the inventors completed the invention.

Namely, the invention is an apparatus for production of an aluminum nitride single crystal that produces the aluminum nitride single crystal by heating an aluminum nitride raw material to sublimate the raw material, thereby to recrystallize the aluminum nitride onto a seed crystal, which includes a growth vessel that accommodates the aluminum nitride raw material, and is composed of a material that has corrosion resistance with respect to the aluminum gas generated upon sublimation of the aluminum nitride raw material, and a heating element that is arranged on the outside of the growth vessel, and heats the aluminum nitride raw material through the growth vessel, wherein the growth vessel includes a main body which has an accommodation section that accommodates the aluminum nitride and a lid which seals the accommodation section of the main body hermetically, and wherein the heating element is composed of a metal material containing tungsten.

According to this production apparatus, the aluminum nitride raw material is accommodated in the accommodation section in the main body of the growth vessel, and the seed crystal is fixed onto the lid, and the accommodation section is sealed hermetically by the lid. Then, the heating element generates heat, and the aluminum nitride raw material is heated through the growth vessel and sublimated. At this time, aluminum gas and nitrogen gas are generated. Then, aluminum nitride is recrystallized onto the seed crystal fixed on the lid, and thus an aluminum nitride single crystal is produced. At this time, the heating element arranged on the outside of the growth vessel is composed of a metal material containing tungsten. Therefore, mixing of carbon into the grown single crystal of aluminum nitride from the heating element disappears. As a result, mixing of carbon into the aluminum nitride single crystal can be lowered sufficiently. In addition, the growth vessel is composed of a material that has corrosion resistance with respect to the aluminum gas. Therefore, corrosion of the growth vessel by the aluminum gas is sufficiently suppressed. Therefore, leaking of the aluminum gas from the growth vessel is sufficiently suppressed, and mixing of aluminum into the heating element is sufficiently suppressed. As a result, it becomes possible to sufficiently reduce the difference of the thermal expansion coefficients in the heating element. Therefore, it is possible to sufficiently suppress deformation of the heating element or generation of the crack in the heating element at the time of temperature-fall of the heating element.

The material that constitutes the growth vessel in the apparatus for production of an aluminum nitride single crystal described above is preferably carbide or nitride of a metal that has 1.37 folds or more and 1.85 folds or less of the ion radius than that of aluminum.

In this case, it is possible to suppress formation of a solid solution by substitution with a portion of aluminum of the aluminum gas generated by sublimation of the aluminum nitride raw material since the metal in the carbide or nitride of the metal described above has greater ion radius than the radius of aluminum ion as described above. Therefore, the carbide or nitride of the metal described above is more excellent in the corrosion resistance with respect to the aluminum gas. Accordingly, the carbide or nitride of the metal has an advantage that impurities are less likely to be mixed into the aluminum nitride single crystal.

The material that constitutes the growth vessel in the apparatus for production of an aluminum nitride single crystal described above is preferably at least one kind selected from a group consisting of tantalum carbide, zirconium nitride, tungsten nitride and tantalum nitride.

These materials have an advantage that impurities are further less likely to be mixed into the aluminum nitride single crystal since the materials are more excellent in the corrosion resistance with respect to the aluminum gas, and chemically more stable.

The metal material that constitutes the heating element in the apparatus for production of an aluminum nitride single crystal described above is preferably a tungsten element.

In this case, with the tungsten element as the metal material of the heating element, it is possible to further improve the heat resistance of the heating element, and it is possible to further facilitate repetitive use of the apparatus for production of an aluminum nitride single crystal.

The heating element is preferably in contact with the growth vessel in the apparatus for production of an aluminum nitride single crystal described above.

In this case, heat transfer from the heating element to the growth vessel is effectively performed, and thus the sublimation of the aluminum nitride raw material can be performed more effectively.

The heating element may be also alienated from the growth vessel in the apparatus for production of an aluminum nitride single crystal described above. Also in this case, it is possible to heat the aluminum nitride raw material through the growth vessel by radiant heat from the heating element. In addition, when the heating element is alienated from the growth vessel, the aluminum gas is diluted and then brought into contact with the heating element even if the aluminum gas is leaked out of the growth vessel. Therefore, it is possible to more sufficiently suppress the reaction of the tungsten and the aluminum gas, in comparison to a case where the heating element is in contact with the growth vessel, and more sufficiently suppress deformation of the heating element at the time of temperature-fall or generation of the crack in the heating element.

In addition, the invention is a method for production of an aluminum nitride single crystal that produces the aluminum nitride single crystal using the apparatus for production of an aluminum nitride single crystal described above, which includes a first process of accommodating the aluminum nitride raw material in the accommodation section in the main body of the growth vessel, fixing a seed crystal onto the lid, and sealing the accommodation section hermetically with the lid; and a second process of rendering the heating element to generate heat, and heating the aluminum nitride raw material through the growth vessel to sublimate the raw material, thereby to recrystallize the aluminum nitride onto the seed crystal fixed onto the lid and thus produce the aluminum nitride single crystal.

According to this production method, mixing of carbon into the grown single crystal of aluminum nitride from the heating element disappears since the heating element arranged on the outside of the growth vessel is composed of a metal material containing tungsten. As a result, mixing of carbon into the aluminum nitride single crystal can be lowered sufficiently. In addition, the growth vessel is composed of a material that has corrosion resistance with respect to the aluminum gas. Therefore, corrosion of the growth vessel by the aluminum gas is sufficiently suppressed. Therefore, leaking of the aluminum gas from the growth vessel is sufficiently suppressed, and mixing of aluminum into the heating element is sufficiently suppressed. As a result, it becomes possible to sufficiently reduce the difference of the thermal expansion coefficients in the heating element, and it is possible to sufficiently suppress generation of the crack in the heating element at the time of temperature-fall of the heating element.

EFFECT OF THE INVENTION

According to the invention, provided is an apparatus and a method for production of an aluminum nitride single crystal that can sufficiently lower the mixing amount of carbon into the crystal of aluminum nitride, and allows repetitive use.

BRIEF DESCRIPTION OF DRAWINGS

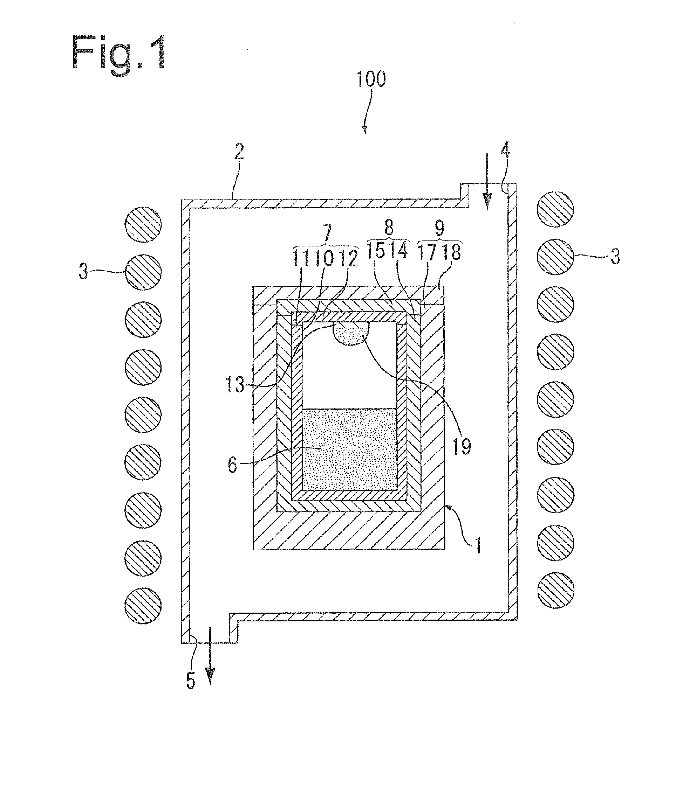

FIG. 1 is a sectional diagram that illustrates one embodiment of an apparatus for production of an aluminum nitride single crystal pertaining to the invention.

MODE (S) FOR CARRYING OUT THE INVENTION

Hereinafter, embodiments of the invention will be explained in detail with reference to the drawing.

FIG. 1 is a sectional diagram that illustrates one embodiment of the apparatus for production of an aluminum nitride single crystal pertaining to the invention. As illustrated in FIG. 1, the apparatus for production of an aluminum nitride single crystal (hereinafter, simply referred to as the "production apparatus") 100 consists of a crystal growth section 1 where growth of an aluminum nitride single crystal 19 is performed, a reception section 2 that receives the crystal growth section 1, and a high frequency coil 3 that is wound around the reception section 2. In the reception section 2, a gas inlet 4 and a gas outlet 5 are formed, and inert gas is introduced through the gas inlet 4 from an inert gas supply device (not illustrated). The gas in the reception section 2 is discharged through the gas outlet 5 by a decompression device (for example, vacuum pump). Wherein, as the inert gas, nitrogen gas, argon gas or the like is used. In addition, an orifice (not illustrated) for receiving the crystal growth section 1 is also formed in the reception section 2.

The crystal growth section 1 includes a growth vessel 7 that accommodates an aluminum nitride raw material 6, a heating element 8 that is arranged on the outside of the growth vessel 7, and an insulating material 9 that covers the heating element 8.

As the growth vessel 7, for example, a crucible is used. Accordingly, the growth vessel 7 includes a main body 11 which has an accommodation section 10 that accommodates the aluminum nitride raw material 6, and a lid 12 which hermetically seals the accommodation section 10 of the main body 11. A seed crystal 13 is fixed onto the surface of the side of the accommodation section 10 of the lid 12. The growth vessel 7 is composed of a material that has corrosion resistance with respect to the aluminum gas. Such material is preferably a carbide or nitride of a metal that has 1.37 folds or more and 1.85 folds or less of the ion radius than that of aluminum. In this case, it is possible to suppress formation of a solid solution by substitution with a portion of aluminum of the aluminum gas generated by sublimation of the aluminum nitride raw material since the metal in the carbide or nitride of the metal described above has greater ion radius than the radius of aluminum ion as described above. Therefore, the carbide or nitride of the metal described above is more excellent in the corrosion resistance with respect to the aluminum gas. Accordingly, the impurities are unlikely mixed into the aluminum nitride single crystal. Examples of such carbide or nitride of a metal described above include tantalum carbide (TaC), zirconium nitride, tungsten nitride and tantalum nitride and the like. These may be used alone or in combination of two or more kinds. These materials are more excellent in the corrosion resistance with respect to the aluminum gas, and particularly chemically stable, and thus have an advantage that the impurities are less likely mixed into the aluminum nitride single crystal. Among them, tantalum carbide is preferable since it is particularly excellent in the corrosion resistance with respect to the aluminum gas.

As the heating element 8, for example, a crucible is used. Accordingly, the heating element 8 includes a main body 14 that accommodates the growth vessel 7, and a lid 15 which seals hermetically the main body 14. The heating element 8 functions as a heating element that heats the aluminum nitride raw material 6 through the growth vessel 7, and is in contact with the growth vessel 7. The heating element 8 is applied with high frequency magnetic field by the high frequency coil 3, which renders the inductive current to flow, and generates heat.

The heating element 8 is composed of a material that has greater corrosion resistance with respect to the aluminum gas generated upon sublimation of the aluminum nitride raw material 6 than the growth vessel 7, namely, a metal material containing a tungsten metal. Examples of such metal material include a tungsten element, and an alloy of tungsten with a metal such as rhenium, iron, nickel or copper. Among them, the tungsten element is preferable since it is excellent in the heat resistance.

The insulating material 9 includes a main body 17 that accommodates the heating element 8 and a lid 18 which seals hermetically the main body 17. The insulating material 9 is a material for effectively transferring the heat from the heating element 8 to the growth vessel 7, and is composed of for example, carbon and the like.

Next, the method for production of an aluminum nitride single crystal using the production apparatus 100 described above will be explained.

First, the crystal growth section 1 is rendered to be in the state where the lid 18 of the insulating material 9, the lid 15 of the heating element 8, and the lid 12 of the growth vessel 7 are removed.

Next, the aluminum nitride raw material 6 is accommodated in the accommodation section 10 of the growth vessel 7. On the other hand, the seed crystal 13 is fixed onto the lid 12. As the seed crystal 13, aluminum nitride (AlN) is usually used, but silicon carbide (SiC) or the like may be also used.

Then, the accommodation section 10 of the main body 11 of the growth vessel 7 is sealed hermetically by the lid 12. At this time, the seed crystal 13 is directed to the side of the accommodation section 10 by the lid 12. Subsequently, the main body 14 of the heating element 8 is sealed hermetically by the lid 15. Further subsequently, the main body 17 is sealed hermetically by the lid 18 (the first process).

Then, the crystal growth section 1 is received into the inner section from the orifice of the reception section 2.

Next, the reception section 2 is vacuum-aspired with a decompression device. After that, inert gas is introduced to the reception section 2 from the gas inlet 4, and the gas in the reception section 2 is discharged from the gas outlet 5. Thus, the surroundings of the crystal growth section 1 are placed under inert gas atmosphere. Herein, examples of the inert gas include, for example, nitrogen gas, argon gas and the like. In addition, at this time, internal pressure of the reception section 2 is preferably 1.3 to 101 kPa, and more preferably 13.3 to 80.0 kPa.

Next, high frequency current is applied to the high frequency coil 3, thereby to apply high frequency magnetic field to the heating element 8. Then, inductive current flows on the heating element 8, and the heating element 8 generates heat. Then, the heat of the lid 15 of the heating element 8 is transferred to the aluminum nitride raw material 6 through the growth vessel 7, and the aluminum nitride raw material 6 is heated, and sublimated. At this time, the heating element 8 is in contact with the growth vessel 7, and thus the heat of the heating element 8 is effectively transferred to the growth vessel 7, and the aluminum nitride raw material 6 is effectively heated.

Thus, when the aluminum nitride raw material 6 is heated to a temperature of the sublimation point or higher, aluminum gas and nitrogen gas are generated from the aluminum nitride raw material 6.

At this time, in the growth vessel 7, the temperature of the aluminum nitride raw material 6 (hereinafter, referred to as the "temperature of the raw material section") is set up to higher than the temperature of the aluminum nitride single crystal 19 (hereinafter, referred to as the "temperature of the growth section"). Herein, the temperature of the raw material section specifically refers to the temperature of the bottom of the main body 11, and the temperature of the growth section specifically refers to the temperature of the lid 12. With such setting of the temperature profile of the growth vessel 7, aluminum gas and nitrogen gas adhere to the seed crystal 13 fixed onto the lid 12 thereby to be recrystallized, and the aluminum nitride single crystal 19 grows. Thus, the aluminum nitride single crystal 19 is produced (the second process).

Herein, the temperature of the raw material section is preferably 1800°C or higher, and more preferably 2000°C or higher. In this case, it is possible to increase the growth speed in comparison to a case where the temperature of the raw material section is 1800°C or lower. However, the temperature of the raw material section is preferably set up to be lower than the melting point of the growth vessel 7.

In addition, the temperature of the growth section may be lower than the temperature of the raw material section, but is preferably lower only by 50°C to 200°C than the temperature of the raw material section. In this case, the single crystal is easily obtained in comparison to a case of temperatures other than the range described above. Namely, precipitation of a multicrystal is more sufficiently suppressed, or the crystal grows easily in comparison to a case of temperatures other than the range described above.

Control of the temperature of the raw material section and the temperature of the growth section may be performed by measuring the temperature of the raw material section and the temperature of the growth section with radiation thermometers arranged, for example, on the bottom of the main body 14 of the heating element 8, and on the lid 15, respectively, and controlling the output of the high frequency current flowing on the high frequency coil 3 based on the measurement results.

In addition, the heating element 8 arranged on the outside of the growth vessel 7 is composed of a metal material containing tungsten. Therefore, mixing of carbon into the aluminum nitride single crystal 19 grown from the heating element 8 disappears. As a result, the mixing amount of carbon into the aluminum nitride single crystal 19 can be lowered sufficiently.

In addition, the growth vessel 7 is composed of a material that has corrosion resistance with respect to the aluminum gas, and thus corrosion of the growth vessel 7 by the aluminum gas is sufficiently suppressed. Therefore, leaking of the aluminum gas from the growth vessel 7 is sufficiently suppressed, and mixing of aluminum into the heating element 8 is sufficiently suppressed. As a result, it becomes possible to sufficiently reduce the difference of the thermal expansion coefficients in the heating element 8, and it is possible to sufficiently suppress deformation of the heating element 8 or generation of the crack in the heating element 8 at the time of temperature-fall of the heating element 8. Accordingly, the production apparatus 100 can be used not only once, but repetitively.

The invention is not limited to the embodiments described above. For example, in the embodiments described above, the growth vessel 7 is in contact with the heating element 8, but the growth vessel 7 may be alienated from the heating element 8. Also in this case, the aluminum nitride raw material 6 can be heated through the growth vessel 7 by radiant heat from the heating element 8. In addition, when the heating element 8 is alienated from the growth vessel 7, the aluminum gas is diluted and then brought into contact with the heating element 8 even if the aluminum gas is leaked out of the growth vessel 7. Therefore, it is possible to more sufficiently suppress the reaction of the tungsten and the aluminum gas, in comparison to a case where the heating element 8 is in contact with the growth vessel 7, and more sufficiently suppress deformation of the heating element 8 at the time of temperature-fall or generation of the crack in the heating element 8. Meanwhile, the heating element used in the invention is not necessarily a crucible, and may have various shapes such as a plate shape, a globe shape and a rod shape. In addition, the heating element is not limited to one, but may have multiple heating sections. Herein, the multiple heating sections may be in contact with, or alienated from each other.

In addition, in the embodiments described above, the heating element 8 generates heat with inductive heat by the high frequency coil 3, but the high frequency coil 3 is not necessarily needed. In this case, the heating element 8 may be rendered to generate heat by resistance heat.

Further, in the embodiments described above, the production apparatus 100 includes the reception section 2 and the high frequency coil 3 in addition to the crystal growth section 1, but the production apparatus 100 may be composed of the crystal growth section 1 only.

EXAMPLES

Hereinafter, the details of the invention will be specifically explained with Examples, but the invention is not limited to the Examples mentioned below.

(Example 1)

An aluminum nitride single crystal was produced using the production apparatus illustrated in FIG. 1 by the procedures described below. Namely, first, the lid 18 of the insulating material 9 composed of carbon was removed, the lid 15 of the heating element 8 composed of a tungsten element was removed, and the lid 12 of the growth vessel 7 composed of tantalum carbide (TaC) was removed. Then, aluminum nitride powders as the raw material were accommodated in the accommodation section 10 of the growth vessel 7. On the other hand, the seed crystal 13 having 2 inch diameter and 0.5 mm thickness was supported by an adhesive onto the lid 12. At this time, as the seed crystal, 6H-SiC (0001) was used.

Then, the accommodation section 10 of the main body 11 of the growth vessel 7 was sealed hermetically with the lid 12. Subsequently, the main body 14 of the heating element 8 was sealed hermetically by the lid 15, and finally the main body 17 was sealed hermetically by the lid 18.

Then, the crystal growth section 1 was installed in the reception section 2. Next, the reception section 2 was vacuum- aspired using a vacuum pump. After that, nitrogen gas as inert gas was introduced to the reception section 2 at 500 sccm of the flow rate from the gas inlet 4, and the gas in the reception section 2 was discharged from the gas outlet 5. Thus, the pressure in the reception section 2 was kept to 100 Torr.

Next, high frequency magnetic field was applied to the high frequency coil 3 to render the heating element 8 to generate heat, and the aluminum nitride powders were heated through the growth vessel 7. At this time, the temperature of the raw material section and the temperature of the growth section of the growth vessel 7 were set to 1870°C and 1800°C, respectively. Then, the aluminum nitride single crystal was grown over 200 h.

(Example 2)

An aluminum nitride crystal was grown in a way similar to the way of Example 1 except that the seed crystal was changed to the aluminum nitride crystal manufactured in Example 1, the pressure in the reception section was changed to 250 Torr, and the temperature of the growth section and the temperature of the raw material section were changed to 2000°C and 2100°C, respectively as listed in Table 1.

(Example 3)

An aluminum nitride single crystal was grown in a way similar to the way of Example 1 except that the seed crystal was changed to the aluminum nitride single crystal manufactured in Example 1, the pressure in the reception section was changed to 500 Torr, and the temperature of the growth section and the temperature of the raw material section were changed to 2200°C and 2320°C, respectively as listed in Table 1.

(Comparative Example 1)

An aluminum nitride crystal was grown in a way similar to the way of Example 1 except that the material constituting the heating element was changed to graphite as listed in Table 1.

(Comparative Example 2)

An aluminum nitride crystal was grown in a way similar to the way of Example 2 except that the material constituting the heating element was changed to graphite, and the seed crystal was changed to aluminum nitride as listed in Table 1.

(Comparative Example 3)

An aluminum nitride crystal was grown in a way similar to the way of Example 3 except that the material constituting the growth vessel was changed to a tungsten element, and the heating element was not used as listed in Table 1.

For the aluminum nitride single crystals obtained in Examples 1 to 3 and Comparative Examples 1 to 3, the growth speed, the crystallinity, the carbon concentration, and the presence or absence of the crack in the growth vessel were investigated by the procedures described below.

(Growth speed)

The thickness of the aluminum nitride single crystal was measured, and the growth speed was calculated based on the formula mentioned below:

```
Growth speed (μm/h) = (Thickness of aluminum nitride

single crystal)/200 h.  The results are listed in Table 1.
```

(Crystallinity)

For the aluminum nitride single crystal, the locking curve of the reflection of aluminum nitride (0002) was obtained using an X ray diffraction apparatus. Then, the full width at half maximum (FWHM) of this locking curve was measured. The results are listed in Table 1.

(Carbon concentration)

For the aluminum nitride single crystal, the quantitative analysis of carbon concentration was performed with secondary ion mass spectrometry (SIMS). The results are listed in Table 1.

(Presence or absence of crack in growth vessel)

The presence or absence of the crack in the growth vessel was visually observed. The results are listed in Table 1.

[Table 1]

| | Growth vessel | Heating element | Seed crystal | Pressure in reception section (Torr) | Temperature of growth section (°C) | Temperature of raw material section (°C) | Growth speed (μm/h) | FWHM (arcsec) | C concentration (ppm) | Presence or absence of crack in growth vessel |
|---|---|---|---|---|---|---|---|---|---|---|
| Example 1 | TaC | W | SiC | 100 | 1800 | 1870 | 40 | 150 | 10 | Absent |
| Example 2 | TaC | W | AlN | 250 | 2000 | 2100 | 150 | 60 | 30 | Absent |
| Example 3 | TaC | W | AlN | 500 | 2200 | 2320 | 300 | 40 | 60 | Absent |
| Comparative Example 1 | TaC | C | SiC | 100 | 1800 | 1870 | 40 | 400 | 150 | Absent |
| Comparative Example 2 | TaC | C | AlN | 250 | 2000 | 2100 | 150 | 300 | 15000 | Absent |
| Comparative Example 3 | W | - | AlN | 500 | 2200 | 2320 | 300 | 800 | 10 | Present |

From the results listed in Table 1, it was found out that the aluminum nitride single crystals of Examples 1 to 3 had less than 100 ppm of the carbon concentration, and had no generation of the crack in the growth vessel. In comparison to this, it was found out that the aluminum nitride single crystals of Comparative Examples 1 to 2 had very high carbon concentration of 150 to 15000 ppm, and had no sufficiently lowered mixing amount of carbon although they had no generation of the crack in the growth vessel.

In addition, it was found out that the aluminum nitride single crystal of Comparative Example 3 had generation of the crack in the growth vessel although it had very small carbon concentration of 10 ppm. It is considered that the generation of the crack is due to the fact that tungsten of the growth vessel reacts with aluminum, and the growth vessel is volume-expanded, which applies stress to the aluminum nitride single crystal, resulting in deformation of the aluminum nitride single crystal. In addition, the growth vessel became very brittle, and was difficult to use multiple times.

Meanwhile, it was found out that any of the aluminum nitride single crystals of Examples 1 to 3 had small FWHM, and good crystallinity. In comparison to this, the aluminum nitride single crystal of Comparative Example 1 had broad FWHM and low crystallinity possibly due to high carbon concentration. In addition, the aluminum nitride single crystal of Comparative Example 2 also had broad FWHM and low crystallinity. The aluminum nitride single crystal of Comparative Example 3 had quite broad FWHM, and quite low crystallinity.

From those described above, it was confirmed that according to the apparatus and the method for production of a nitride single crystal of the invention, it is possible to sufficiently lower the mixing amount of carbon into the crystal of aluminum nitride and allow repetitive use.

EXPLANATIONS OF REFERRENCE NUMERALS

| | |
|---|---|
| 6 | Aluminum nitride raw material |
| 7 | Growth vessel |
| 8 | Heating element |
| 10 | Accommodation section |
| 11 | Main body |
| 12 | Lid |
| 13 | Seed crystal |
| 14 | Main body |
| 15 | Lid |
| 19 | Aluminum nitride single crystal |
| 100 | Apparatus for production of aluminum nitride single crystal |

**Claims**

1. An apparatus for production of an aluminum nitride single crystal that produces the aluminum nitride single crystal by heating an aluminum nitride raw material to sublimate the raw material, thereby to recrystallize the aluminum nitride onto a seed crystal, the apparatus comprising:

   a growth vessel that accommodates the aluminum nitride raw material, and is composed of a material that has corrosion resistance with respect to the aluminum gas generated upon sublimation of the aluminum nitride raw material, and
   a heating element which is arranged on the outside of the growth vessel, and heats the aluminum nitride raw material through the growth vessel, wherein
   the growth vessel comprises a main body which has the accommodation section that accommodates the aluminum nitride and a lid which seals the accommodation section of the main body hermetically, and wherein
   the heating element is composed of a metal material containing tungsten.

2. The apparatus for production of an aluminum nitride single crystal according to claim 1, wherein the material that constitutes the growth vessel is a carbide or nitride of a metal that has 1.37 folds or more and 1.85 folds or less of the ion radius than that of aluminum.

3. The apparatus for production of an aluminum nitride single crystal according to claims 1 or 2, wherein the material that constitutes the growth vessel is at least one kind selected from a group consisting of tantalum carbide, zirconium nitride, tungsten nitride and tantalum nitride.

**4.** The apparatus for production of an aluminum nitride single crystal according to any one of claims 1 to 3, wherein the metal material that constitutes the heating element is a tungsten element.

**5.** The apparatus for production of an aluminum nitride single crystal according to any one of claims 1 to 4, wherein the heating element is in contact with the growth vessel.

**6.** The apparatus for production of an aluminum nitride single crystal according to any one of claims 1 to 4, wherein the heating element is alienated from the growth vessel.

**7.** A method for production of an aluminum nitride single crystal that produces the aluminum nitride single crystal using the apparatus for production of an aluminum nitride single crystal according to any one of claims 1 to 6, which comprises:

a first process of accommodating the aluminum nitride raw material in the accommodation section in the main body of the growth vessel, fixing a seed crystal onto the lid, and sealing the accommodation section hermetically with the lid, and

a second process of rendering the heating element to generate heat, and heating the aluminum nitride raw material through the growth vessel to sublimate the raw material, thereby to recrystallize the aluminum nitride onto the seed crystal fixed onto the lid and thus produce the aluminum nitride single crystal.

# Fig.1

| **INTERNATIONAL SEARCH REPORT** | International application No. |
|---|---|
| | PCT/JP2011/075793 |

**A.  CLASSIFICATION OF SUBJECT MATTER**
*C30B29/38(2006.01)i*

According to International Patent Classification (IPC) or to both national classification and IPC

**B.  FIELDS SEARCHED**

Minimum documentation searched (classification system followed by classification symbols)
C30B1/00-35/00

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
WPI

**C.  DOCUMENTS CONSIDERED TO BE RELEVANT**

| Category* | Citation of document, with indication, where appropriate, of the relevant passages | Relevant to claim No. |
|---|---|---|
| X | JP 2007-500664 A  (SiCrystal AG.), 18 January 2007 (18.01.2007), paragraphs [0053], [0033]; fig. 3 & EP 1567696 A          & WO 2005/012602 A1 & DE 10335538 A          & DE 502004010263 D & KR 10-2006-0036370 A  & CN 1717508 A & AT 446394 T | 1-5,7 |
| X | JP 2006-273585 A  (NGK Insulators, Ltd.), 12 October 2006 (12.10.2006), paragraphs [0015], [0031]; fig. 1 (Family: none) | 1-4,6,7 |

☐  Further documents are listed in the continuation of Box C.      ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 December, 2011 (09.12.11) | 27 December, 2011 (27.12.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005519841 A

**Non-patent literature cited in the description**

- **C. HARTMANN et al.** *Journal of Crystal Growth,* 2008, vol. 310, 930